**Europäisches Patentamt**

**European Patent Office**

**Office européen des brevets**

(19)

(11) Veröffentlichungsnummer : **0 048 938**
**B1**

# (12) EUROPÄISCHE PATENTSCHRIFT

(45) Veröffentlichungstag der Patentschrift :
30.07.86

(21) Anmeldenummer : 81107533.2

(22) Anmeldetag : 22.09.81

(51) Int. Cl.⁴ : **H 05 K   7/20**, H 05 K   3/36,
H 01 L 23/36, H 01 L 25/04

(54) Gehäuseloses, senkrecht steckbares Singel-in-line-Schaltungsmodul.

(30) Priorität : 25.09.80 DE 3036196
26.05.81 DE 3121000
29.05.81 DE 3121515
11.06.81 DE 3123201

(43) Veröffentlichungstag der Anmeldung :
07.04.82 Patentblatt 82/14

(45) Bekanntmachung des Hinweises auf die Patenterteilung : 30.07.86 Patentblatt 86/31

(84) Benannte Vertragsstaaten :
AT CH DE FR GB IT LI NL SE

(56) Entgegenhaltungen :
DE-A- 2 165 649
DE-A- 2 344 145
DE-A- 2 516 007
DE-A- 2 806 518
DE-A- 2 815 776
DE-B- 1 243 254
DE-B- 2 107 786
DE-U- 7 434 817
US-A- 4 041 524
SIEMENS-ZEITSCHRIFT, Band 48, Nr. 10, 1974 Berlin und München E. LEHMANN et al. "Leistungshalbleiter in Scheibenbauform und ihre Anwendungsmöglichkeiten" Seiten 791 bis 798
IBM TECHNICAL DISCLOSURE BULLETIN, Band 22, Nr. 8A, Januar 1980 New York R.E. SIMONS "Solid-State Enhanced Cooling Package" Seite 3312

(73) Patentinhaber : Siemens Aktiengesellschaft
Berlin und München Wittelsbacherplatz 2
D-8000 München 2 (DE)

(72) Erfinder : Prussas, Herbert, Dipl.-Ing.
Heinrich-Schütz-Weg 31
D-8000 München 60 (DE)
Erfinder : Stern, Peter, Dipl.-Ing.
Forstenrieder Allee 136a
D-8000 München 71 (DE)

**Beschreibung**

Die Erfindung geht von einem gehäuselosen, mittels Metallstiften senkrecht steckbaren Schaltungsmodul gemäß dem Oberbegriff des Patentanspruchs 1 aus. Ein derartiges Schaltungsmodul ist aus der DE-B-1 243 254 bekannt.

Die Erfindung wurde vor allem als besonders raumsparendes, steifes, leicht kühlbares und leicht herstellbares, hinsichtlich Verlustleistung hoch belastbares Modul entwikkelt, das auch besser sein sollte als die parallel zu Lochplatten anzubringenden Dual-in-line-Schaltungsmodule mit Gehäusen ; und zwar wurde die Erfindung zunächst an sich für ein Codierer-Decodierer-Modul eines digitalen Fernsprech-Vermittlungssystems entwickelt. Ein Fernsprechamt eines solchen Systems enthält z. B. viele Tausend derartiger Module. Die Erfindung ist darüber hinaus aber schlechthin auf alle in diesem Oberbegriff definierten Schaltungsmodule anwendbar.

Aus der genannten Vorveröffentlichung geht zwar nicht hervor, ob dieses bekannte Schaltungsmodul wirklich senkrecht in eine Lochplatte gesteckt werden sollte. Im Prinzip wäre es an sich so aber steckbar, obwohl eine dort auch vorgesehene zweite Metallstiftreihe vermuten läßt, daß es sich auch dort um ein Dual-in-line-Schaltungsmodul handelt.

Dieses vorbekannte Schaltungsmodul gestattet, jedenfalls wenn es senkrecht gesteckt wird, ebenso wie die Erfindung, im Prinzip insbesondere bereits folgende Vorteile auszunutzen :

die Vorderseite ebenso wie die Rückseite des Trägers und damit dort angebrachte Bauteile und Leitungen gut zu belüften, und damit das Schaltungsmodul bzw. seine Bauteile gut kühlen zu können (was bei der Erfindung für einen zuverlässigen Betrieb insbesondere der temperaturabhängigen Widerstände von Widerstandsbahnen und der integrierten Halbleiterschaltungskörper, z. B. von gegen Temperaturschwankungen recht empfindlichen Codierer-Decodierer-Chips, besonders wichtig ist), also die Bauteile vergleichsweise stark mit Strom belasten zu können, bevor Störungen des Betriebs eintreten,

die eigene Steifheit des senkrecht fest in die Lochplatte gesteckten/verlöteten Schaltungsmoduls ähnlich wie eine versteifende Rippe für die Lochplatte wirken lassen zu können, besonders wenn solche rippenförmigen Schaltungsmodule senkrecht sowohl auf die Vorderseite als auch auf die Rückseite der Lochplatte gesteckt werden, so daß, bei hoher Strombelastung bzw. bei starker Erwärmung der Lochplatte und insbesondere bei größerer Länge der die Metallstiftenreihe aufweisenden Trägerkante im Vergleich zur dazu senkrechten Ausdehnung des Trägers, diese Lochplatte sich nicht mehr so leicht wie bei Dual-in-line-Modulen verformen, z. B. wölben bzw. durchbiegen, kann und damit nicht so leicht wie bei Dual-in-line-Modulen den Betrieb des gesamten Gerätes bzw. Systems, z. B. die gleichmäßige Kühlung aller Schaltungsmodule trotz sehr enger Packungsdichte, beeinträchtigen kann,

bei Bedarf sowohl auf der Vorderseite als auch auf der Rückseite des Trägers einige zusätzliche diskrete elektrische Bauteile — z. B. Widerstände und Kondensatoren zur Glättung von Gleichspannungen — mit anbringen zu können,

die Länge der Leitungen unmittelbar auf dem Schaltungsmodul bereits ziemlich kurz machen zu können, wodurch das Schaltungsmodul auch mit besonders hohen Frequenzen betreibbar ist, den auf dem Träger angebrachten integrierten Halbeiterschaltkörper bzw. die Widerstandsbahn bzw. die Widerstandsfläche nun auch unter normalen Umfeldverhältnissen dynamisch, das heißt bei hohen Betriebsfrequenzen, zu verlassig prüfen zu können,

das Schaltungsmodul besonders handlich, insbesondere besonders leicht in eine Lochplatte stecken und löten sowie besonders raumsparend vor seiner Anbringung auf der Lochplatte in Stapeln bzw. Kartons stapeln bzw. lagern zu können,

bei Mängeln im Bauteil, z. B. im integrierten Halbleiterschaltungskörper, die sich erst bei der, bevorzugt dynamischen, Prüfung zeigen, dieses Bauteil manchmal vom Träger wieder entfernen und leicht durch ein anderes gleichartiges Bauteil ersetzen zu können, das nun (vielleicht) ein besseres (dynamisches) Verhalten hat, wobei

das entfernte Bauteil, wenn es ein Halbleiterschaltungskörper ohne Gehäuse ist, vor seinem Entfernen bzw. Wegwerfen besonders wenig Aufwand zu seiner Herstellung erforderte, und

das schließlich angebrachte Bauteil, insbesondere Halbleiterschaltungskörper, mangels eigenen Gehäuses besonders gut kühlbar ist und damit besonders wenig Eigenschaftsänderungen durch wechselnde (lokale) Überhitzungen aufweist,

die Leitungen, insbesondere in Dünnfilmtechnik, entsprechend dem Trägermaterial in an sich bekannter Weise herstellen zu können,

bei derart vergleichsweise dünnen Trägern allgemein die Bauteile und Leitungen auf der Vorderseite des Trägers nicht nur von der Luft auf der Vorderseite des Trägers, sondern auch durch den Träger hindurch von der Luft auf der Rückseite des Trägers kühlen zu können, sowie in entsprechender Weise Bauteile und Leitungen auf der Rückseite des Trägers zusätzlich von der Luft auf der Vorderseite des Trägers kühlen zu können,

eine besonders hohe Packungsdichte auf der Lochplatte bei besonders hoher Kompaktheit der Leitungen und der elektrischen Bauteile auf dem Schaltungsmodul erreichen zu können, und

die elektrische Abschirmung zwischen benachbarten, parallel nebeneinander in der Lochplatte gesteckten Schaltungsmodulen verbessern zu können.

Bei dem vorbekannten Schaltungsmodul besteht der isolierende Träger aus der dünnen aufgewachsenen Oxidschicht des z. B. aus Aluminium bestehenden Kühlbleches. Der Träger stellt dort keinen eigenen massiven Körper dar. Solche Metalloxide haben im allgemeinen einen sehr hohen spezifischen Wärmewiderstand und eine vernachlässigbar kleine Steifheit. Wollte man auf einer solchen Schicht in Drucktechnik einen schichtförmigen Widerstant und/oder Leitungen anbringen, dann müßten diese Bestandteile hohe Einbrenntemperaturen aushalten, was wegen der sehr verschiedenen thermischen Ausdehnungskoeffizienten vor allem auch der Oxidschicht und des Kühlbleches zu Rissen bzw. Abplatzungen der Oxidschicht führen kann.

Die Aufgabe der Erfindung ist, ein Schaltungsmodul gemäß dem Oberbegriff des Patentanspruchs 1 in Richtung längs der Reihe der Metallstifte so zu versteifen, daß in torsions- und biegespannungsempfindlichen Trägern, z. B. Keramikträgern, solche Spannungen vermieden werden.

Diese Aufgabe wird durch die im Patentanspruch 1 angegebenen Merkmale gelöst.

Darüber hinaus gestattet die Erfindung, Vorteile zu erreichen, welche durch das oben genannte bekannte Schaltungsmodul noch nicht erreicht sind. Die Erfindung gestattet nämlich zusätzlich,

auch den Träger des Schaltungsmoduls, einschließlich eventueller Durchkontaktierungen zwischen Leitungen auf der Vorder- und der Rückseite, vergleichsweise leicht beliebig, insbesondere durch Schneiden, Stanzen, Bohren und Laserbeschuß, bearbeiten bzw. formen zu können, besonders wenn er aus Kunststoff, z. B. aus Polyamid, besteht,

den Träger platzsparend und materialsparend bei Bedarf auch sehr dünn und weitgehend bruchfest machen zu können,

die Metallstifte solide und leicht am Träger anbringen zu können, ohne einen Kurzschluß über das Kühlblech zu riskieren und ohne den Träger zu zerstören,

wegen der Möglichkeit, das Kühlblech erst nach dem Anbringen z. B. von Leitungen und/oder von schichtförmigen Widerständen auf den Träger zu kleben, weniger Schwierigkeiten wegen verschiedener thermischer Ausdehnungskoeffizienten von Träger und Kühlblech zu haben,

eine bei Bedarf sogar sehr hohe spezifische thermische Leitfähigkeit des Trägers ausnutzen zu können, also eine gute Wärmeableitung trotz der Dicke des steifen stabilen Trägers erreichen zu können,

das Kühlblech solide an der Seitenfläche befestigen zu können,

den Träger und damit auch das Schaltungsmodul gleichzeitig nahezu beliebig steif machen und damit auch die Lochplatte noch besser versteifen zu können, ohne dazu ein dickeres Kühlblech zu benötigen,

durch diese Versteifung das Schaltungsmodul bzw. seine Bauteile besonders stark mit Strom bzw. Verlustwärme belasten zu können, und

die elektrische Abschirmung zwischen benachbarten, parallel nebeneinander in die Lochplatte gesteckten Schaltmodulen verbessern zu können.

Durch eine Reihe weiterer Druckschriften sind weitere, mehr oder weniger ähnliche Schaltungsmodule vorbekannt. Bei dem in der DE-A-28 06 518 angegebenen Schaltungsmodul ist das durch einen Chip gebildete Bauteil nicht auf dem Träger, sondern direkt auf dem Kühlblech angebracht, und zwar innerhalb eines Loches im Träger. Eine solche Verbindung der Potentiale eines Bauteils und des Kühlbleches ist nur in Sonderfällen zulässig. Die Erfindung vermeidet eine solche Einengung der Anwendung. Außerdem ist bei der Erfindung im Prinzip auch vermeidbar, mit relativ hohem Aufwand ein Loch im Träger, z. B. in einem Keramikträger anbringen zu müssen. Außerdem gestattet das Kühlblech der Erfindung, Verlustwärme auch vom Kühlblech und damit rundum um das Schaltungsmodul direkt an das strömungsfähige Kühlmedium, also z. B. Luft, abzuleiten, statt es nur als Verlustwärme weiterleitendes Zwischenblech zu verwenden, das Verlustwärme an feste Kühlkörper weiterleitet. Bei der Erfindung handelt es sich vor allem um ein Kühlblech, anstatt im wesentlichen nur um ein Zwischenblech.

Bei dem durch DE-A-21 65 649 vorbekannten Schaltungsmodul ist ein kunststoffumhüllter Transistor mit besonders gestaltetem, zur Verbesserung der Wärmeabstrahlung mit schwarzer Farbe überzogenen Kühlblech beschrieben.

Bei dem durch DE-A-28 15 776 vorbekannten Schaltungsmodul ist das elektrische Bauteil direkt in einer Mulde eines leitenden Trägers angebracht, der seinerseits auch zu Wärmeweiterleitung, insbesondere zu einer zusätzlich angebrachten Wärmesenke dient.

Bei dem durch DE-A-23 44 145 vorbekannten Schaltungsmodul sind keine Metallstifte als äußere Anschlüsse jeweils am Träger selber angebracht, sondern in eigenen getrennten Stützen. Die Erfindung ist entsprechend kompakter gestaltet und braucht sowohl bei ihrer Herstellung als auch bei ihrer Anwendung weniger Aufwand.

Das durch DE-U-74 34 817 vorbekannten Dual-in-line-Schaltungsmodul ist mittels besonderer Stecker in wenig steifer Weise parallel statt senkrecht in eine Lochplatte zu stecken. Es ist also wegen dieser Stecker aufwendiger als die Erfindung aufgebaut. Es ist auch schlechter kühlbar als die Erfindung, es handelt sich nämlich auch hier wieder im wesentlichen um wärmeweiterleitende Zwischenbleche statt um direkt vom strömungsfähigen Kühlmedium gekühlte Kühlbleche, wobei schon wenige Schaltungsmodule überdies viel Platz auf der Lochplatte verbrauchen. Bei der Erfindung ist die solide mechanische Befestigung des Schaltungsmoduls bereits über die Metallstifte erreicht.

Die Erfindung fällt also durch eine besonders günstige Kombination von Eigenschaften gegenüber dem Stand der Technik auf, nämlich besonders durch geschickten steifen einfachen, leicht herstellbaren Aufbau und durch besonders gute Kühlbarkeit trotz evtl. dichtester Anordnung auf der mitversteiften Lochplatte.

Die in den Unteransprüchen genannten Maßnahmen gestatten weitere Vorteile zu erreichen, nämlich die Maßnahme gemäß Patentanspruch 2, das Schaltungsmodul, insbesondere seinen integrierten Halbleiterschaltungskörper, noch besser kühlen zu können,

das Schaltungsmodul in Richtung längs der Reihe der Metallstifte noch mehr versteifen zu können, dadurch

in torsions- und biegespannungsempfindlichen Trägern, wie z. B. Keramikträgern, auftretende Torsions- und Biegespannungen entsprechend vermeiden zu können, daher

das Schaltungsmodul bzw. seine Bauteile noch mehr mit Strom bzw. Verlustleistung belasten zu können ; 3, das Schaltungsmodul, insbesondere seinen integrierten Halbleiterschaltungskörper, noch mehr kühlen zu können, dadurch

das Schaltungsmodul bzw. seine Bauteile noch mehr mit Strom bzw. Verlustleistung belasten zu können, sowie

auf eine Isolation zwischen dem Kühlblech und den zu kühlenden Leitungen und Bauteilen verzichten zu können ; 5, eine besonders gute bzw. rasche Kühlung der betreffenden Leitungen und/oder Bauteile erreichen zu können, besonders falls der Träger, z. B. wenn er aus Leiterplattenmaterial oder Glas besteht und/oder relativ dick ist, relativ schlecht Verlustwärme von seiner einen Seitenfläche zu seiner gegenüberliegenden Seitenfläche leitet,

im Träger durch ungleichmäßige Wärmeverteilung bewirkte innere Zug- und Druckspannungen verringern zu können und dadurch

Verbiegungen des Trägers durch ungleichmäßige Ausdehnungen in seinem Inneren verringern zu können ; 6, die elektrische Isolation zwischen den betreffenden Leitungen und/oder Bauteilen einerseits und dem Kühlblech andererseits erleichtern zu können,

mechanische Spannungen zwischen dem Träger und dem Kühlblech, die durch nicht genügend angepaßte Wärmeausdehnungskoeffizienten des Trägermaterials einerseits und des Kühlblechmaterials andererseits entstehen, mehr oder weniger ausgleichen zu können, und dadurch

Verbiegungen des Schaltungsmoduls, welche sogar ein Abplatzen des Kühlbleches von der bedeckten Seitenfläche bewirken und/oder ein Zerbrechen des Trägers und ein Unterbrechen von Leitungen bewirken könnten, jedenfalls weitgehend verringern zu können ; 7, das Schaltungsmodul noch besser kühlen zu können, sowie

das Schaltungsmodul noch besser versteifen zu können und dadurch

das Schaltungsmodul bzw. seine Bauteile noch mehr mit Strom bzw. Verlustleistung belasten zu können ; 8, das betreffende Kühlblech, insbesondere mittels einer dünnen Klebschicht, dicht auf den Träger kleben zu können, und

innerhalb der Aussparung Platz für vergleichsweise dicke Bauteile reservieren zu können ; 9, einen soliden Schutz der in den Aussparungen angebrachten Bauteile erreichen zu können ; 10, zu große mechanische Spannungen zwischen dem Träger und dem Kühlblech, die durch nicht genügend angepaßte Wärmeausdehnungskoeffizienten des Trägermaterials einerseits und des Kühlblechmaterials andererseits entstehen können, jedenfalls weigehend vermeiden zu können, und dadurch

Verbiegungen des Schaltungsmoduls, welche sogar ein Abplatzen des Kühlbleches von der bedeckten Seitenfläche oder ein Zerbrechen des Trägers und Unterbrechen von Leitungen bewirken könnten, jedenfalls weitgehend vermeiden zu konnen ; 11, das Kühlblech mit besonders geringem Verlustwärme-Übergangswiderstand an der Seitenfläche befestigen zu können ; 12, den Fortsatz des Kühlbleches, das bevorzugt L-förmig oder T-förmig ist und das mit einem seiner auch für sich vom Kühlmedium gekühlten Schenkel am Träger angeklebt ist, zur Überprüfung, Reparatur und/oder Montage der sonstigen, unter dem abgewinkelten Fortsatz beschirmt angebrachten Bauteile jedenfalls zeitweise aus der abgewinkelten Lage wegschwenken zu können und später erneut in die abgewinkelte Lage zurückschwenken und dann befestigen zu können ; 13, in einfacher Weise den zeitweise störenden abgewinkelten Fortsatz des Kühlbleches mittels einer einfachen Drehbewegung beliebig oft wegschwenken und wieder zurückschwenken zu können, 14, dabei besonders leicht eine Arretierurng des beweglichen Fortsatzes des Kühlbleches in der endgültigen beschirmenden Lage erreichen zu können ; 15 und 16, jeweils eine völlige Entfernung des weiteren Schenkels des Kühlbleches und damit eine besonders gute Zugänglichkeit der sonstigen Bauteile erreichen zu können ; sowie 17, eine besonders gute Kühlung erreichen zu können.

Die Erfindung und deren Weiterbildungen werden anhand der in den Figuren schematisch (nämlich insbesondere wegen der Übersichtlichkeit nicht maßstabgetreu) gezeigten Beispiele der Erfindung, vor allem anhand von Querschnitten durch verschiedene Beispiele, weiter erläutert.

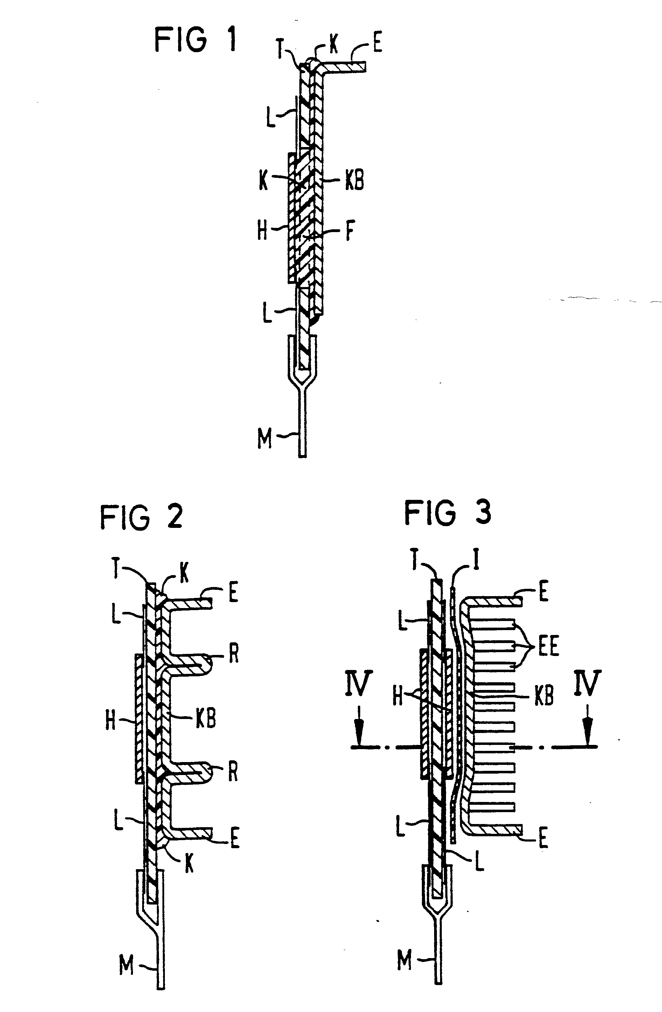

Dabei zeigen die Figur 1 einen Schnitt durch ein Ausführungsbeispiel mit einem Fenster im Träger und mit dem Fortsatz an der von den Metallstiften abgewendeten Kante des Kühlbleches, 2 einen Schnitt durch ein Ausführungsbeispiel mit zwischen den Kühlblechkanten liegenden Kühlrippen im Kühlblech, 3 und 4 zueinander senkrechte Schnitte durch ein Ausführungsbeispiel mit

einem weiteren Fortsatz nahe der Trägerkante, längs welcher die Metallstifte angebracht sind,

zwei kammförmigen zusätzlichen Fortsätzen und

Leitungen und einem Halbleiterschaltungskörper auch zwischen dem Kühlblech und dem Träger, 5 ein der Figur 1 entsprechendes Ausführungsbeispiel, wobei sonstige Bauteile unter dem Fortsatz des Kühl-Kühlbleches angebracht sind, 6 zwei auf eine Lochplatte gesteckte Ausführungsbeispiele mit beweglichem Fortsatz, Scharnier und Anschlag, sowie 7 bis 9 Details eines Ausführungsbeispiels mit auf den Fortsatz steckbarem weiteren Schenkel.

Der in Figur 1 gezeigte Schnitt durch ein erstes, relativ einfach aufgebautes Ausführungsbeispiel des gehäuselosen, senkrecht steckbaren Single-in-line-Schaltungsmoduls zeigt, ebenso wie etliche in anderen Figuren gezeigte Schnitte durch weitere Ausführungsbeispiele, jeweils einen Träger T, der, wie auch in drei nicht vorveröffentlichten DE-A-30 33 856, DE-A-30 33 881 und DE-A-30 33 900 beschrieben ist, z. B. aus Kunststoff-Folie oder Keramik besteht. Dieser Träger T dient zum Tragen von einer Reihe von jeweils in der Trägerebene liegenden Metallstiften M als äußeren Anschlüssen, über die das Schaltungsmodul in Single-in-line-Weise senkrecht steckbar ist, vgl. insbesondere die Figuren 1 bis 3 und 5 bis 7. Der Träger T trägt außerdem Leitungen L sowie elektrische Bauteile, darunter mindestens einen integrierten gehäuselosen Halbleiterschaltungskörper H, der vom Fachmann im allgemeinen « Chip » genannt wird, und/oder zumindest eine, z. B. mäanderförmige Widerstandsbahn bzw. Widerstandsfläche. Alle gezeigten Ausführungsbeispiele, nicht nur das in Figur 1 gezeigte, weisen auf einer Seitenfläche des Trägers T und damit auf einer Seitenfläche des Schaltungsmoduls ein metallisches Kühlblech, vgl. KB, auf, das die betreffende Seitenfläcje mehr als zur Hälfte, also weitgehend bedeckt. Dieses z. B. 0,2 mm bis 0,8 mm dicke Kühlblech KB kann hierbei in elektrischer Hinsicht floaten oder z. B. an ein Gleichpotential, z. B. an Erde gelegt sein. Das Kühlblech KB ist mittels eines in den Figuren 1 bis 3 sowie 6 und 7 gezeigten Klebers K befestigt. Das Kühlblech KB klebt mittelbar oder unmittelbar auf dem Träger T, also z. B. evtl. auch auf an dem Träger T haftenden Metallflecken und/oder Bauteilen H und/oder Isolierfolien I, vgl. insbesondere Figur 3. In Figur 3 ist der Übersichtlichkeit wegen der Kleber nicht mehr angegeben.

Das Kühlblech KB bildet also kein geschlossenes Gebilde, kein Gehäuse. Statt dessen bedeckt es so eine Seitenfläche des senkrecht steckbaren Single-in-line-Schaltungsmoduls, daß im Betrieb die Kühlluft gut am Kühlblech vorbeifließen kann, selbst wenn eine Vielzahl solcher Schaltungsmodule eng benachbart untereinander parallel auf eine Lochplatte gesteckt sind. Das Kühlblech KB verteilt die jeweils auf einer Fläche im Bauteil H, z. B. im Halbleiterschaltungskörper H, und in den jeweils betreffenden Leitungen L entstandene Verlustwärme rasch auf eine große Kühlblechfläche. Daher gestattet das Kühlblech KB, jeweils das Schaltungsmodul, insbesondere seinen integrierten Halbleiterschaltungskörper H, noch besser als ohne Kühlblech KB zu kühlen und damit das Schaltungsmodul bzw. seine Bauteile H und seine Leitungen L entsprechend stärker mit Strom bzw. Verlustwärme als ohne Kühlblech KB zu belasten.

Unter « Kühlung » ist bei allen Ausführungsbeispielen der Erfindung also auch zu verstehen, daß nicht nur die Wärme an die Kühlluft abgegeben wird, sondern auch, daß die hohe punktuelle Temperatur auf dem Träger mittels des Kühlbleches vermindert wird, indem die Wärme vom Punkt, wo sie entsteht, auf die große Fläche des Kühlbleches mit dessen hohem Wärmeleitwert schnell verteilt wird, so daß die Temperatur an jenem Punkt alleine schon wegen dieser schnellen Wärmeverteilung weniger hoch ist, also nicht nur wegen der darauf folgenden Abführung dieser Wärme an die vorbeiströmende Kühlluft.

Das Kühlblech KB macht das Schaltungsmodul gleichzeitig noch steifer als wenn es kein Kühlblech hätte, wodurch auch die Lochplatte, in die das Schaltungsmodul später gesteckt ist, noch besser versteift wird und wodurch ebenfalls das Schaltungsmodul bzw. seine Bauteile H entsprechend nochmals stärker mit Strom bzw. Verlustwärme belastet werden können als ohne diese zusätzliche Versteifung.

Außerdem verbessert das Kühlblech KB die elektrische Abschirmung zwischen benachbarten, parallel nebeneinander in die Lochplatte gesteckten Schaltungsmodulen, besonders wenn das Kühlblech KB geerdet wird.

Falls der Träger T, wie im Ausführungsbeispiel von Figur 1, ein Fenster F aufweist (z. B. um den Halbleiterschaltungskörper H durch das Fenster F hindurch über das Kühlblech KB noch stärker zu kühlen als wenn der, z. B. aus Glas oder Keramik bestehende Träger T fensterlos wäre), dann kann es oft ratsam sein, mit dem — bevorzugt einen vergleichsweise geringen Wärmewiderstand aufweisenden und dazu z. B. Metallpulver oder Keramikpulver aufweisenden — Kleber K auch das Fenster F auszufüllen und den Kleber sogar eine (z. B. durch Isolierlack geschützte) Oberfläche des Bauteils H berühren zu lassen, vgl. Figur 1. Dadurch wird die Verlustwärmeableitung vom Bauteil H über das Kühlblech KB zur außen fließenden Kühlluft weiter verbessert, ohne daß gleichzeitig das Bauteil H, in die Streukapazitäten erhöhender Weise, zu eng benachbart zum metallischen Kühlblech KB angebracht wurde.

Beim in Figur 1 gezeigten Ausführungsbeispiel weist außerdem das Kühlblech KB parallel zur Reihe der Metallstifte M einen abgewinkelten Fortsatz E auf. Dieser Fortsatz E verbessert die Kühlung des Schaltungsmoduls, insbesondere seines integrierten Halbleiterschaltungskörpers, weil er die von der Kühlluft gekühlte Kühlblechoberfläche vergrößert, und zwar ohne den Luftwiderstand für die parallel zur Metallstiftenreihe fließenden Kühlluft wesentlich zu erhöhen. Außerdem versteift der Fortsatz E das Schaltungsmodul längs der Reihe der Metallstifte M noch mehr als wenn es keinen Fortsatz E hätte, wodurch auch die Lochplatte in einem zusätzlichen Maße steifer wird und die Verlustwärme entsprechend noch größer werden darf, das heißt, daß das Schaltungsmodul bzw. seine Bauteile H schon allein wegen der verbesserten Steifheit noch mehr mit Strom bzw. Verlustleistung belastet werden dürfen.

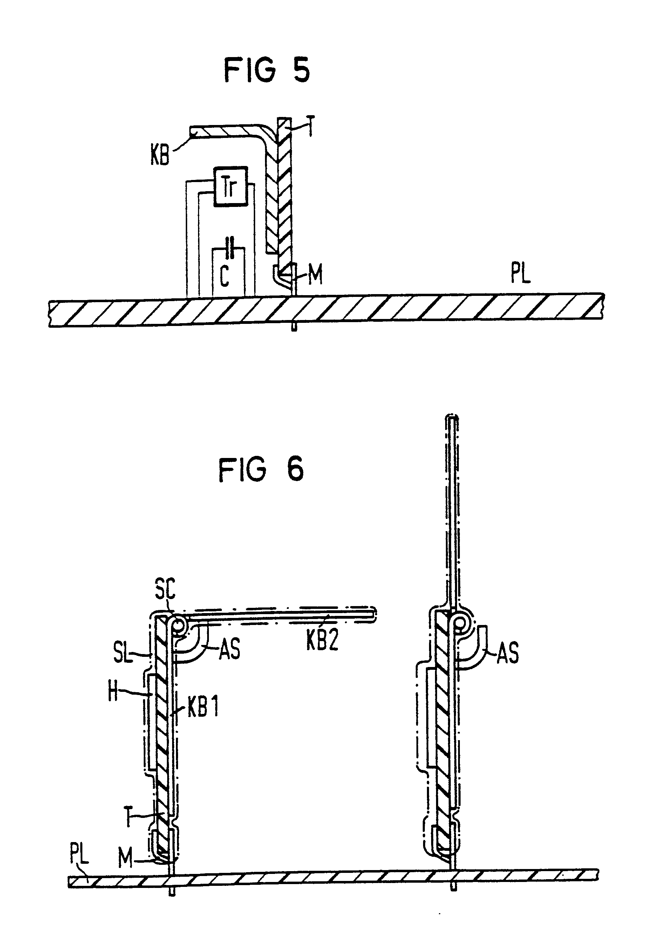

Erfindungsgemäß wird der Fortsatz E, vgl. Figur 1, längs der von den Metallstiften M abgewendeten Kante des Kühlbleches KB angebracht, statt ihn z. B. längs der den Metallstiften M benachbarten Kante des Kühlbleches KB anzubringen. Damit wird die Kühlung und die Verlustwärmebelastbarkeit weiter verbessert, weil in Betrieb die Strömungsgeschwindigkeit der Kühlluft an der abgewendeten Kante großer als an der benachbarten Kante ist. Ferner gestattet der an der abgewendeten Kante angebrachte Fortsatz E, in durch diesen Fortsatz E beschirmter, also geschützter Weise sonstige Bauteile, vgl. Tr und C in Figur 5, auf derselben Lochplatte anzubringen.

Zur weiteren Verbesserung der Kühlung kann man an beiden Kanten je einen derartigen Fortsatz E anbringen, vgl. die Figuren 2 und 3.

Bei dem in Figur 2 gezeigten Schnitt durch ein zweites Ausführungsbeispiel weist das Kühlblech KB, und zwar parallel zur Reihe der Metallstifte M und zwischen den parallel zur Reihe der Metallstifte M liegenden Kanten des Kühlbleches KB, zusätzlich eine oder mehrere Kühlrippen R auf. Diese Kühlrippen R wirken jeweils ähnlich wie ein Fortsatz E, das heißt, sie verbessern die Kühlung des Schaltungsmoduls, insbesondere seines integrierten Halbleiterschaltungskörpers H, und sie erhöhen die Steifheit des Schaltungsmoduls in Richtung längs der Reihe der Metallstifte M, wodurch das Schaltungsmodul bzw. seine Bauteile H entsprechend stärker mit Strom bzw. Verlustleistung belastbar sind.

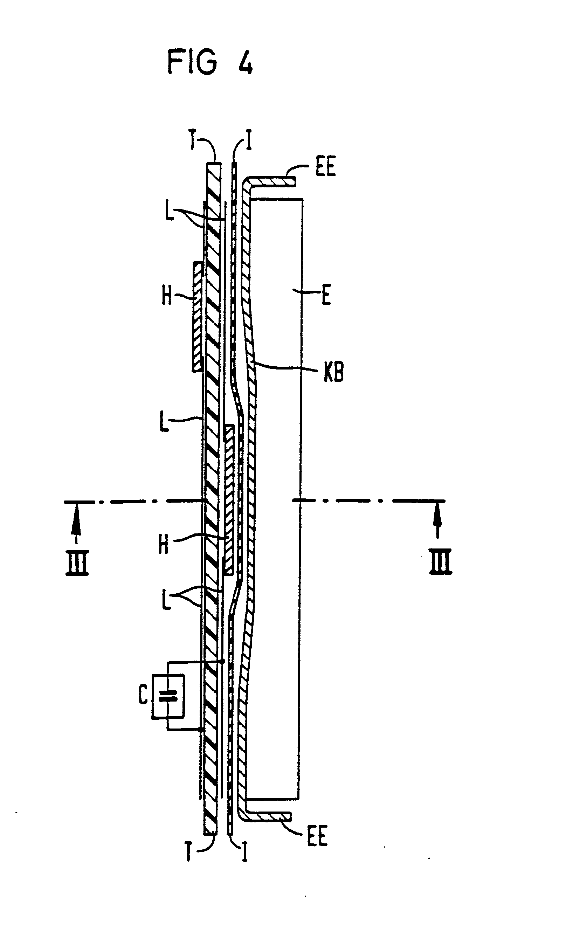

Figur 3 zeigt einen Schnitt durch ein Ausführungsbeispiel, bei dem das Kühlblech KB zusätzlich längs seiner beiden senkrecht zur Reihe der Metallstifte M gerichteten Kanten des Kühlbleches KB je einen abgewinkelten, kammförmigen zusätzlichen Fortsatz EE aufweist, vgl. auch den dazu senkrechten Schnitt durch das gleiche Ausführungsbeispiel in Figur 4. Bei diesem — hier zwei Bauteile H, je einen auf jeder Seitenfläche des Trägers T, zusammen jeweils mit Leitungen L auf beiden Seitenflächen aufweisenden — Schaltungsmodul ist das die zwei massiven Fortsätze E und die zwei Kammförmigen zusätzlichen Fortsätze EE aufweisende Kühlblech KB sicherheitshalber nicht direkt auf die Seitenfläche geklebt. Statt dessen ist dazwischen zur Vermeidung unbeabsichtigter Kurzschlüsse noch eine Isolierfolie I eingeklebt, wobei der Kleber in den Figuren 3 und 4 wegen der Übersichtlichkeit jeweils nicht mit angegeben ist. Diese Isolierfolie kann überdies doppelseitig selbstklebend sein und dadurch die Montage des Schaltungsmoduls erheblich vereinfachen, und zwar nicht nur in diesem Ausführungsbeispiel.

Die zusätzlichen Fortsätze EE vergrößern nochmals die von der Kühlluft umflossenen Kühlblechoberflächen. Sie gestatten also, eine besonders gute bzw. rasche Kühlung der Leitungen L und/oder Bauteile H des Schaltungsmoduls zu erreichen, und zwar eine verbesserte Kühlung besonders jener Leitungen L und Bauteile H zu erreichen, die unmittelbar zwischen dem Kühlblech KB und der davon bedeckten Seitenfläche des Trägers T liegen, besonders falls der Träger T — z. B. wenn er aus Leiterplatten oder Glas besteht und/oder relativ dick ist — relativ schlecht Verlustwärme von seiner einen Seitenfläche zu seiner gegenüberliegenden Seitenfläche leitet. Dadurch werden auch die im Träger T durch ungleichmäßige Wärmeverteilung bewirkten inneren Zug- und Druckspannungen verringert und die dadurch bewirkten Verbiegungen des Trägers T, nämlich die durch ungleichmäßige Ausdehnung im Träger T bewirkten Verbengungen desselben verringert.

Bei diesen in den Figuren 3 und 4 gezeigten Ausführungsbeispielen bedeckt also das Kühlblech KB eine mehrere Leitungen L und das Bauteil H tragende Seitenfläche des Trägers T, im Gegensatz zu den in den Figuren 1 und 2 gezeigten Ausführungsbeispielen — dort bedeckt nämlich das Kühlblech KB die den Leitungen L und dem Bauteil H gegenüberliegende Seitenfläche des Trägers T, wodurch dort auf eine besondere Beachtung der Isolation zwischen dem Kühlblech KB und den zu kühlenden Leitungen L und den Bauteilen H im allgemeinen verzichtet werden kann.

Bei dem in den Figuren 3 und 4 gezeigten — übrigens in Figur 4 einen zusätzlichen diskreten, nicht integrierten Kondensator C hoher Kapazität tragenden — Ausführungsbeispielen wurde das Kühlblech KB vor dem Ankleben an seiner die Träger-Seitenfläche bedeckenden Fläche leicht gewölbt, damit Unebenheiten, die durch das dort mitbedeckte Bauteil H bewirkt werden, angenähert ausgeglichen werden. Diese Wölbung ist unnötig oder jedenfalls kleiner, falls die — hier bevorzugt relativ dicke — Isolierfolie I ein Fenster im Bereich dieses mitbedeckten Halbleiterschaltungskörpers H aufweist, so daß dann die Isolierfolie I nur die Leitungen L dieser bedeckten Seitenfläche bedeckt und dort Kurzschlüsse verhindert. Im übrigen ebnet eine solche Isolierfolie I mit Fenster die vom Kühlblech KB bedeckte Seitenfläche des Schaltungsmoduls ein, wodurch die Kühlung im allgemeinen sogar eher noch weiter verbessert als verschlechtert wird. Hierbei sind Kurzschlüsse zwischen dem bedeckten, in den Isolierfolienfenster liegenden Bauteil H und dem Kühlblech KB bei Bedarf, besonders wenn die Isolierfolie relativ dünn ist und daher mangels ausreichender Dicke keinen Luftspalt zwischen dem Bauteil H und dem Kühlblech KB erzeugt, durch eine dünne Lackschicht auf dem betreffenden Bauteil H bzw. auf der betreffenden Stelle der Kühlblechoberfläche vermeidbar.

Die Isolierfolie I zwischen dem Träger T und dem Kühlblech KB hat nicht nur den Vorteil, die elektrische Isolation zwischen den betreffenden Leitungen L und/oder Bauteilen H einerseits und dem Kühlblech KB andererseits zu erreichen. Auch mechanische Spannungen zwischen dem Träger und dem Kühlblech KB, die durch nicht genügend angepaßte Wärmeausdehnungskoeffizienten des Trägermaterials einerseits und des Kühlblechmaterials andererseits entstehen, werden von der Isolierfolie I mehr oder weniger ausgeglichen, wodurch Verbiegungen des Schaltungsmoduls, welche sogar ein Abplatzen des Kühlblechs KB von der bedeckten Seitenfläche bewirken kann, ebenfalls verringert werden.

Bei Bedarf kann man sogar den Träger T auf seinen beiden Seitenflächen von je einem metallischen Kühlblech KB weitgehend bedecken, wodurch das Schaltungsmodul, wenn auch mit erhöhtem Aufwand, noch besser bzw. schneller kühlbar ist, das Schaltungsmodul noch mehr versteift wird und dadurch das Schaltungsmodul bzw. seine Bauteile H noch mehr mit Strom bzw. Verlustleistung belastbar sind.

Bei dem erfindungsgemäßen Schaltungsmodul mit zwei Kühlblechen kann das eine Kühlblech eine Aussparung bzw. ein Fenster aufweisen, innerhalb dessen ein elektrisches Bauteil H, z. B. ein Halbleiterschaltungskörper H, angebracht ist. Dieses Bauteil H kann hier so dick sein, daß das Kühlblech, wäre es völlig eben und hätte es kein Fenster, nicht dicht auf den Leitungen L. bzw. auf dem Träger T angebracht werden könnte. Hier ist also das Bauteil H dick gegen den mit Kleber gefüllten Spalt zwischen dem Träger T bzw. seinen flachen Leitungen L einerseits und dem Kühlblech andererseits. Diese Aussparung im Kühlblech gestattet also, das Kühlblech ganz dicht auf den Träger T bzw. auf seine Leitungen L zu kleben, im Gegensatz zur fensterlosen Variante mit dann oft dicker Kleberschicht K. Zum Schutz des in der Aussparung angebrachten Bauteils, zum Schutz vor allem von Chips kann zusätzlich das in der Aussparung angebrachte Bauteil H durch einen Schutzlack, z. B. durch einen Kunststoffisolator, bedeckt werden.

Mechanische Spannungen zwischen dem Träger und dem Kühlblech, die an sich durch nicht genügend angepaßte Wärmeausdehnungskoeffizienten des Trägermaterials einerseits und des Kühlblechmaterials andererseits entstehen können, sind weitgehend auch dadurch vermeidbar, daß der Träger T aus im Vergleich zum Kühlblechmaterial elastischem Material, z. B. aus einem entsprechenden Kunststoff besteht. Dadurch werden also Verbiegungen des Schaltungsmoduls, welche sogar ein Abplatzen des Kühlblechs von der bedeckten Seitenfläche bewirken könnten, jedenfalls weitgehend vermeidbar.

Das Prinzip der Erfindung ist auch auf solche Träger T anwendbar, deren punktuell starke thermische Belastung nicht unbedingt allein von einem solchen, z. B. ebenfalls auf den Träger T geklebten, Halbleiterschaltungskörper H (Chip) ausgeht. Statt dieses Halbleiterschaltungskörpers H, oder zusätzlich zu ihm können auch andere, den Träger T punktuell stark thermisch belastende Bauteile, nämlich eine (z. B. mäanderförmige) Widerstandsbahn bzw. Widerstandsfläche als Bauteil H unmittelbar auf dem Träger T angebracht sein.

Die Aufgabe der mit den Figuren 5 bis 9 erläuterten Beispiele der Erfindung wird anhand der Figur 5 erläutert.

Diese Figur 5 zeigt die Lochplatte PL, auf der das Schaltungsmodul, das den Träger T und ein hier L-förmiges Kühlblech KB enthält, mittels seiner Metallstifte M angebracht ist. Der abgewinkelte Fortsatz des hier L-förmigen Kühlbleches KB beschirmt die darunter raumsparend angebrachten sonstigen Bauteile. Gezeigt ist hier als Beispiel ein auf diese Weise beschirmter Kondensator C und Transistor TR. An sich können auf der Lochplatte PL eng nebeneinander eine Vielzahl solcher Schaltungsmodule angebracht sein, vgl. auch Figur 6, die jedes für sich jeweils etliche sonstige Bauteile C, Tr beschirmen können. Die Kühlluft, die über die Lochplattenoberfläche gleichsam senkrecht auf die Zeichnungsebene bläst, kühlt dann nicht nur die elektrischen Bestandteile der Schaltungsmodule, zum Teil mittels deren angeklebten Kühlbleche KB, vgl. Figur 5, sondern auch alle diese beschirmten Bauteile C, Tr. Bei der Überprüfung, Reparatur und Montage der sonstigen Bauteile C, Tr steht aber der beschirmende abgewinkelte Fortsatz bzw. Schenkel des Kühlbleches KB im Wege, vgl. auch den Schenkel E in Figur 1.

Die Aufgabe der folgenden Beispiele der Erfindung ist es, den Fortsatz des Kühlbleches KB, das bevorzugt L-förmig oder T-förmig ist und das mit einem seiner Schenkel am Träger T angeklebt ist, jedenfalls zeitweise (z. B) während des Betriebs der voll bestückten Lochplatte PL) wieder vom Träger so zu entfernen und später erneut am Träger T so zu befestigen, daß eine Überprüfung, Reparatur und/oder Montage der sonstigen Bauteile C, Tr (Z. B. im Betrieb sogar während des Betriebes der Lochplatte PL) möglich ist, ohne das ganze Schaltungsmodul aus der Lochplatte PL entfernen zu müssen.

In den Figuren 5 und 6 sind Details eines Ausführungsbeispiels dieser Weiterbildung der Erfindung gezeigt, bei dem das metallische Kühlblech zwei Schenkel aufweist und z. B. zu Abschirmungszwecken bevorzugt geerdet ist. Dabei ist dieses Kühlblech KB1, KB2 jeweils mit dem ersten seiner Schenkel KB1 auf einer Seitenfläche des Trägers T dauerhaft so angeklebt, daß es den Träger T dort zumindest weitgehend bedeckt. Längs der von den Metallstiften M abgewendeten Kante des festgeklebten ersten Schenkels des Kühlbleches KB1 ist als zweiter Schenkel KB2 der abgewinkelte Fortsatz angebracht, der die Kühlung weiter verbessert. Bei diesem Ausführungsbeispiel ist der weitere Schenkel KB2 in beweglicher Weise angebracht, um leicht an die darunter in beschirmter Weise angebrachten sonstigen Bauteile C, Tr, vgl. Figur 5 mit Figur 6, herankommen zu können. Bei dem in Figur 6 gezeigten Ausführungsbeispiel ist nämlich der zweite Schenkel KB2 über ein Scharnier SC mit dem angeklebten ersten Schenkel KB1 verbunden, wodurch der zweite Schenkel KB2 bei Bedarf weggeschwenkt werden kann, vgl. das rechte Beispiel in Figur 6. Danach kann man den zweiten Schenkel KB2 wieder in die beschirmende Lage schwenken, vgl. das linke Beispiel in Fig. 6.

Damit der weitere Schenkel KB2 in seiner beschirmenden Lage arretiert ist, so daß er bei Erschütterungen seine Lage nicht mehr verändert, kann das Scharnier SC eine große innere Reibung aufweisen. Man kann aber zu diesem Zweck auch einen aushärtenden Lacktropfen auf dem Scharnier SC anbringen, der beim späteren Schwenken des zweiten Schenkels KB2 bricht und dann das Schwenken zuläßt und der dann zum erneuten Arretieren leicht weider erneuert werden kann. Auch zum Befestigen des Schaltungsmoduls auf der Lochplatte PL kann der zweite Schenkel KB2 aus seiner beschirmenden Lage herausgeschwenkt werden.

Damit der zweite Schenkel KB2 leicht in seine beschirmende Lage geschwenkt und dort arretiert werden kann, ist bei dem in Figur 6 bezeigten Beispiel zusätzlich in der Nähe des Scharniers SC ein Anschlag AS angebracht, der seinerseits den minimalen Winkel, hier ein rechter Winkel, zwischen dem ersten und dem zweiten Schenkel KB1, KB2 festgelegt.

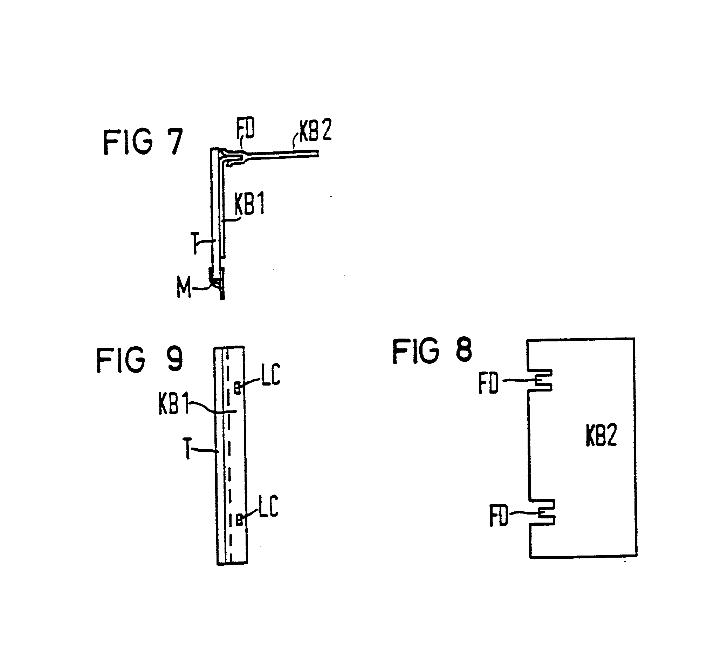

In der Figur 7 ist die Seitenansicht eines Ausführungsbeispieles gezeigt, bei dem ein weiterer Schenkel KB22 auf den Fortsatz des Kühlbleches steckbar ist. Dies kann z. B. dadurch erreicht werden, daß der dauerhaft festgeklebte erste Schenkel KB1 des Kühlbleches, vgl. Figur 7, ein Blech mit einem kurzen abgewinkelten Fortsatz ist, wobei über diesen Fortsatz die federnden Klauen FD des aufsteckbaren weiteren Schenkels KB22 gesteckt sind. Der weitere Schenkel KB22 ist auch hier mittels eines aushärtenden Lacktropfens, der auf die Federn FD aufgebracht wird, arretierbar. Die Arretierung kann auch dadurch erreicht bzw. verbessert werden, daß die in Figur 8 in der Draufsicht gezeigten Federn FD des weiteren Schenkels KB2 in Vertiefungen bzw. Löchern LC, vgl. Figur 9 einrasten, die in dem Fortsatz des Kühlbleches KB1 in Figuren 7 und 9, angebracht sind.

Zur Verbesserung der Kühlung kann jeweils außerdem, vgl. Figur 6, der Träger T und/oder sein Kühlblech KB1, KB2 und/oder seine elektrischen Bauteile H bei allen Ausführungsbeispielen der Erfindung mindestens teilweise mit dunklem, insbesondere schwarzen Schutzlack SL bedeckt werden. Ein solcher Schutzlack Sl strahlt bekanntlich die Wärme besser ab als eine helle oder als eine metallische Oberfläche.

Wie aus der obigen Beschreibung hervorgeht, ist auch das auf die Entfernbarkeit bzw. Schwenkbarkeit eines Schenkels des Kühlbleches gerichtete Prinzip der in Verbindung mit den Figuren 6 bis 9 erläuterten Ausführungsbeispiele der Erfindung auf Schaltungsmodule anwendbar, deren punktuell thermische Belastung statt von einem Halbleiterschaltungskörper H, oder zusätzlich zu ihm, von einem oder mehreren, z. B. mäanderförmigen Widerstandsbahnen bzw. Widerstandsflächen ausgeht.

## Patentansprüche

1. Gehäuseloses, mittels Metallstiften (M) senkrecht steckbares Schaltungsmodul mit
    einem elektrisch isolierenden Träger (T) zum Tragen von
        einer Reihe der in der Trägerebene liegenden Metallstifte (M) als äußeren elektrischen Anschlüssen,
        Leitungen (L) und
        einem oder mehreren elektrischen Bauteilen, darunter mindestens einem integrierten gehäuselosen Halbleiterschaltungskörper (H) und/oder mindestens einer Widerstandsbahn bzw. Widerstandsfläche, und
    einem metallischen Kühlblech (KB), welches wärmeableitend großflächig den Träger (T) bedeckt, insbesondere für Codierer-Decodierer-Module eines digitalen Fernsprech-Vermittlungssystems, dadurch gekennzeichnet, daß
    sein aus einem Isolator, z. B. aus Kunststoff-Folie oder Keramik, hergestellter massiver single-in-line-steckbarer Träger (T), jedoch nicht seine Metallstifte (M), auf einer Seitenfläche mit dem, z. B. geerdeten, Kühlblech (KB), von dem im Betrieb Verlustleistung fast ausschließlich durch vorbeifließende Kühlluft abgeführt wird, zumindest weitgehen beklebt ist, wobei das Kühlblech (KB) parallel zur Reihe der Mettalstifte (M) und längs der von den Metallstiften (M) abgewendeten Kante des Kühlbleches (KB) einen abgewinkelten Fortsatz (E, KB2) zur Erhöhung seiner mechanischen Steifheit aufweist.

2. Schaltungsmodul nach Patentanspruch 1, dadurch gekennzeichnet, daß
    das Kühlblech (KB), bevorzugt parallel zur Reihe der Metallstifte (M) und zwischen den parallel zur Reihe der Metallstifte (M) liegenden Kanten des Kühlbleches (KB), eine oder mehrere Kühlrippen (R) aufweist (Fig. 2).

3. Schaltungsmodul nach einem der Patentansprüche 1 oder 2, dadurch gekennzeichnet, daß
    das Kühlblech (KB) längs zumindest einer senkrecht zur Reihe der Metallstifte (M) gerichteten Kante des Kühlbleches (KB) einen abgewinkelten, bevorzugt kammförmigen, zusätzlichen Fortsatz (EE) aufweist (Fig. 3 und 4).

4. Schaltungsmodul nach einem der vorhergehenden Patentansprüche, dadurch gekennzeichnet, daß
    das Kühlblech (KB) die den Leitungen (L) und dem Bauteil/den Bauteilen (H) gegenüberliegende Seitenfläche des Trägers (T) bedeckt (Fig. 1, 2, 6).

5. Schaltungsmodul nach einem der Patentansprüche 1 bis 3, dadurch gekennzeichnet, daß
    das Kühlblech (KB) eine Seitenfläche des Trägers (T), welche Leitungen (L) und das Bauteil/die Bauteile (H) trägt, bedeck (Fig. 3 und 4).

6. Schaltungsmodul nach Patentanspruch 5, dadurch gekennzeichnet, daß
    zwischen dem Kühlblech (KB) einerseits und den betreffrenden Leitungen (L) und Bauteil/Bauteilen (H) andererseits eine Isolierfolie (I) eingefügt ist (Fig. 3 und 4).

7. Schaltungsmodul nach Patentanspruch 6, dadurch gekennzeichnet, daß

der Träger (T) auf seiner freien Seitenfläche von einem weiteren metallischen Kühlblech (KB) zumindest weitgehend bedeck ist.

8. Schaltungsmodule nach Patentanspruch 7, dadurch gekennzeichnet, daß

eines der Kühlbleche (KB) eine Aussparung bzw. ein Fenster aufweist, innerhalb dessen mindestens eines der elektrischen Bauteile, z. B. der Halbleiterschaltungskörper (H), angebracht ist.

9. Schaltungsmodul nach Patentanspruch 8, dadurch gekennzeichnet, daß

das in der Aussparung angebrachte Bauteil (H) durch einen Schutzlack, z. B. einen Kunststoffisolator, bedeckt ist.

10. Schaltungsmodul nach einem der vorhergehenden Patentansprüche, dadurch gekennzeichnet, daß

der Träger aus einem im Vergleich zum Kühlblechmaterial elastischen Kunststoff besteht.

11. Schaltungsmodul nach einem der vorhergehenden Patentansprüche, dadurch gekennzeichnet, daß

der Kleber (K) Metallpulver bzw. Keramikpulver enthält.

12. Schaltungsmodul nach einem der vorhergehenden Patentansprüche, dadurch gekennzeichnet, daß

bevorzugt parallel zur Reihe der Metallstifte (M) und längs der von den Metallstiften (M) abgewendeten Kante des Kühlbleches (KB1), der abgewinkelte Fortsatz des Kühlbleches (KB2) um eine parallel zur Ebene des Trägers (T) verlaufende Achse (SC) beweglich ist (Fig. 6).

13. Schaltungsmodul nach Patentanspruch 12, dadurch gekennzeichnet, daß

der abgewinkelte Fortsatz (KB2) über ein Scharnier (SC) mit dem aufgeklebten Schenkel des Kühlbleches (KB1) verbunden ist (Fig. 6).

14. Schaltungsmodul nach Patentanspruch 13, dadurch gekennzeichnet, daß

in der Nähe des Scharniers (SC) ein Anschlag (AS) angebracht ist, der den minimalen Winkel zwischen dem Fortsatz und dem aufgeklebten Schenkel (KB1, KB2) festlegt (Fig. 6).

15. Schaltungsmodul nach einem der vorhergehenden Patentansprüche, dadurch gekennzeichnet, daß

ein weitere Schenkel (KB22) auf den Fortsatz des Kühlbleches (KB1) steckbar ist (Fig. 7 bis 9).

16. Schaltungsmodul nach Patentanspruch 15, dadurch gekennzeichnet, daß

der weitere Schenkel (KB22) an den Fortsatz des Kühlbleches (KB1) mittels einer Klammer (FD) anklemmbar ist (Fig. 7 bis 9).

17. Schaltungsmodul nach einem der vorhergehenden Patentansprüche, dadurch gekennzeichnet, daß

der Träger (T) und/oder sein Kühlblech und/oder seine elektrischen Bauteile (H) mindestens teilweise mit dunklem, insbesondere schwarzem Schutzlack (SL) bedeckt ist (Fig. 6).

**Claims**

1. An unencased switching module which can be plugged-in vertically by means of metal pins (M) and which comprises

an electrically insulating carrier (T) for carrying

a row of the metal pins (M) arranged in the plane of the carrier as external electrical terminals,

leads (L),

one or more electrical components, including at least one unencased, integrated semiconductor switching body (H) and/or at least one resistance path or resistance surface, and

a metal cooling plate (KB) which covers the carrier (T) over a large area in heat-dissipating manner, particularly but not exclusively for coder-decoder modules of a digital telephone exchange system, characterised in that

its massive single-in-line-plug-in-type carrier (T) which is made of an insulator, e. g. of plastic film or ceramic, but not its metal pins (M), is, to a large extent, at least connected at one side face to the cooling plate (KB), which is, for example, earthed, by adhesion, power loss during operation being almost exclusively dissipated by passing cooling air, and, in order to increase its mechanical rigidity, the cooling plate (KB) has an angled extension (E, KB2) parallel to the row of the metal pins (M) and along the edge of the cooling plate (KB) which faces away from the metal pins (M).

2. A switching module as claimed in Claim 1, characterised in that

the cooling plate (KB) has one or more cooling ribs (R), preferably parallel to the row of the metal pins (M) and between the edges of the cooling plate (KB) which are parallel to the row of the metal pins (M), (Fig. 2).

3. A switching module as claimed in one of the preceding Claims 1 or 2, characterised in that

the cooling plate (KB) has an angled, preferably comb-shaped, additional extension (EE) along at least one edge of the cooling plate (KB) which is at right angles to the row of the metal pins, (Figs. 3 and 4).

4. A switching module as claimed in one of the preceding Claims, characterised in that

the cooling plate (KB) covers the lateral face of the carrier (T) which is opposite the leads (L) and the component(s) (H), (Fig. 1, 2, 6).

5. A switching module as claimed in one of Claims 1 to 3, characterised in that

the cooling plate (KB) covers a lateral face of the carrier (T), which carries leads (L) and the component(s) (H), (Figs. 3 and 4).

6. A switching module as claimed in Claim 1, characterised in that

an insulating film (I) is inserted between the cooling plate (KB), on the one hand, and the respective leads (L) and component(s) (H), on the other hand, (Figs. 3 and 4).

7. A switching module as claimed in Claim 6, characterised in that

on its free lateral face, the carrier (T) is at least largely covered by a further metal cooling plate (KB).

8. A switching module as claimed in Claim 7, characterised in that

one of the cooling plates (KB) has a recess or a window, within which at least one of the electrical components, e. g. the semiconductor switching body (H), is fixed.

9. A switching module as claimed in Claim 8, characterised in that

the component (H) fixed in the recess s icovered by a protective lacquer, e. g. a synthetic resin insulator.

10. A switching module as claimed in one of the preceding Claims, characterised in that

the carrier consits of a synthetic resin which is elastic in comparison with the material of the cooling plate.

11. A switching module as claimed in one of the preceding Claims, characterised in that

the adhesive (K) contains metal powder, or ceramic powder.

12. A switching module as claimed in one of the preceding Claims, characterised in that

preferably parallel to the row of the metal pins (M) and along the edge of the cooling plate (KB1) which faces away from the metal pins (M), the angled extension of the cooling plate (KB2) is movable about an axis (SC) extending parallel to the plane of the carrier (T), (Fig. 6).

13. A switching module as claimed in Claim 12, characterised in that

the angled extension (KB2) is connected to the stuck-on flank of the cooling plate (KB1) by means of a hinge (SC), (Fig. 6).

14. A switching module as claimed in Claim 13, characterised in that

in the vicinity of the hinge (SC) a stop (AS) is arranged which determines the minimum angle between the extension and the stuck-on flank (KB1, KB2), (Fig. 6).

15. A switching module as claimed in one of the preceding Claims, characterised in that

a further flank (KB22) can be plugged on to the extension of the cooling plate (KB1), (Fig. 7 to 9).

16. A switching module as claimed in Claim 15, characterised in that

the further flank (KB22) can be clamped to the extension of the cooling plate (KB1) by means of a clamp (FD), (Fig. 7 to 9).

17. A switching module as claimed in one of the preceding Claims, characterised in that

the carrier (T) and/or its cooling plate and/or its electrical components (H) are at least partially covered with a dark, in particular a black, protective lacquer (Fig. 6).

**Revendications**

1. Module de circuit sans boîtier, enfichable verticalement au moyen de broches métalliques (M) et comportant :

un support électriquement isolant (T) servant à porter

une série de broches métalliques (M) situées dans le plan du support et constituant des bornes électriques extérieures,

des conducteurs (L) et

un ou plusieurs composants électriques, et au-dessous de ces derniers au moins un corps intégré (H) d'un circuit à semiconducteurs sans boîtier et/ou au moins une voie résistive ou une surface résistive, et

une tôle métallique de refroidissement (KB), qui recouvre sur une surface étendue le support (T) de manière à réaliser une évacuation de chaleur, par exemple pour des modules de codeurs/décodeurs d'un système de commutation téléphonique numérique, caractérisé par le fait que

son support massif (T) du type enfichable à une seule rangée de connexions et constitué par un isolant, par exemple une feuille de matière plastique ou une céramique, mais pas ses broches métalliques (M), est collé au moins dans une large mesure sur une surface latérale à la tôle de refroidissement (KB), par exemple mise à la terre et par laquelle la puissance dissipée est évacuée, en cours de fonctionnement, presqu'exclusivement par l'air de refroidissement circulant le long de cette tôle, la tôle de refroidissement (KB) comportant, parallèlement à la rangée des broches métalliques (M) et le long de son bord tourné à l'opposé des broches métalliques (M), un prolongement coudé (E, KB2) servant à accroître la rigidité mécanique.

2. Module de circuit suivant la revendication 1, caractérisé par le fait que :

la tôle de refroidissement (KB) comporte une ou plusieurs nervures de refroidissement (R), de préférence parallèlement à la rangée des broches métalliques (M) et entre les bords de la tôle de refroidissement (KB) qui sont parallèles à la rangée des broches métalliques (M) (figure 2).

3. Module de circuit suivant l'une des revendications 1 ou 2, caractérisé par le fait que :

la tôle de refroidissement (KB) comporte, le long d'au moins l'un de ses bords, perpendiculaire à la rangée des broches métalliques (M), un prolongement supplémentaire coudé (EE), de préférence en forme de peigne (figures 3 et 4).

4. Module de circuit suivant l'une des revendications précédentes, caractérisé par le fait que :

la tôle de refroidissement (KB) recouvre la surface latérale du support (T), qui est en vis-à-vis des conducteurs (L) et du/des composants (H) (figures 1, 2, 6).

5. Module de circuit suivant l'une des revendications 1 à 3, caractérisé par le fait que :

la tôle de refroidissement (KB) recouvre une surface latérale du support (T), qui porte des conducteurs (L) et le/les composants (H).

6. Module de circuit suivant la revendication 5, caractérisé par le fait que :

une feuille isolante (I) est insérée entre la tôle de refroidissement (KB) d'une part et les conducteurs (L) et le/les composants (H) considérés d'autre part (figures 3 et 4).

7. Module de circuit suivant la revendication 6, caractérisé par le fait que :

le support (T) est recouvert au moins dans une large mesure, sur sa face latérale libre, par une autre tôle métallique de refroidissement (KB).

8. Module de circuit suivant la revendication 7, caractérisé par le fait que :

l'une des tôles de refroidissement (KB) comporte un évidement ou une fenêtre, à l'intérieur de laquelle se trouve disposé au moins l'un des composants électriques, par exemple le corps (H) d'un circuit à semiconducteurs.

9. Module de circuit suivant la revendication 8, caractérisé par le fait que :

le composant (H) disposé dans l'évidement est recouvert par une plaque protectrice, par exemple un isolant en matière plastique.

10. Module de circuit suivant l'une des revendications précédentes, caractérisé par le fait que :

le support est constitué en une matière plastique élastique par rapport au matériau de la tôle de refroidissement.

11. Module de circuit suivant l'une des revendications précédentes, caractérisé par le fait que :

la colle (K) contient une poudre métallique ou une poudre céramique.

12. Module de circuit suivant l'une des revendications précédentes, caractérisé par le fait que :

de préférence parallèlement à la rangée des broches métalliques (M) et le long du bord, tourné à l'opposé de ces dernières, de la tôle de refroidissement (KB1), le prolongement coudé de la tôle de refroidissement (KB2) est mobile autour d'un axe (C) parallèle au plan du support (T) (figure 6).

13. Module de circuit suivant la revendication 12, caractérisé par le fait que :

le prolongement (KB2) est relié par l'intermédiaire d'une charnière (SC) à la branche collée de la tôle de refroidissement (KB1) (figure 6).

14. Module de circuit suivant la revendication 13, caractérisé par le fait que :

à proximité de la charnière (SC) se trouve disposée une butée (AS) qui détermine l'angle minimum entre le prolongement et la branche collée (KB1, KB2) (figure 6).

15. Module de circuit suivant l'une des revendications précédentes, caractérisé par le fait que :

une autre branche (KB22) peut être enfichée sur le prolongement de la tôle de refroidissement (KB1) (figures 7 à 9).

16. Module de circuit suivant la revendication 15, caractérisé en ce que :

l'autre branche (KB22) peut être fixée par serrage sur le prolongement de la tôle de refroidissement (KB1) au moyen d'une pince (FD) (figures 7 à 9).

17. Module de circuit suivant l'une des revendications précédentes, caractérisé par le fait que :

le support (T) et/ou sa tôle de refroidissement et/ou ses composants électriques (H) sont recouverts au moins partiellement par une laque protectrice foncée, notamment noire (SL) (figure 6).

# FIG 1

# FIG 2

# FIG 3

# FIG 4

# FIG 5

# FIG 6

FIG 7

FD KB2

KB1

T

M

FIG 9

KB1

T

LC

LC

FIG 8

FD

KB2

FD